# EUROPEAN PATENT APPLICATION

(11) **EP 0 813 250 A2**
(43) Date of publication of application: **17.12.1997**
(21) Application number: 97304045.4
(22) Date of filing: 09.06.1997
(51) Int. Cl.: H01L 29/06, H01L 29/739

(54) **Trench semiconductor device**

(30) Priority: 13.06.1996 GB 9612397
(71) Applicant: PLESSEY SEMICONDUCTORS LIMITED, Swindon, Wiltshire SN2 2QW (GB)
(72) Inventor: Amaratunga, Gehan A.J., Cambridge CB32 2RW (GB); Udrea, Florin, Cambridge, CB3 0JG (GB)
(74) Representative: Hoste, Colin Francis

(57) **Abstract**

In a trench-based IGBT having a vertical MOS gate set in the side wall of a trench, the voltage breakdown performance can be less than optimum due to the occurrence of high electric field gradients at the edges of the device. An electrically conductive region, which encircles the active region of the device, extends into the substrate of the device to the depth of the bottom of the trench. This electrically conductive region is a semiconductor material having a conductivity type opposite to that of the region underlying the trench. This provides a much improved immunity to electrical breakdown.

## Description

This invention relates to semiconductor devices, and is particularly concerned with trench devices, ie devices in which at least one electrode is set into the wall or bottom of a trench or recess below the upper, usually planar, surface of a semiconductor device. The use of trenches is particularly advantageous for devices such as IGBT's (insulated gate bipolar transistors) which are capable of operating at high power and voltage levels. The limit on the upper value of voltage at which such devices can be used is determined by the breakdown voltage of a device.

In a trench-based device which incorporates a so-called vertical MOS gate set in the side wall of a trench, the breakdown performance can be degraded due to crowding of potential lines around the trench corners, and the effect is of maximum importance at the edge of the device. Within the active area, at high trench density the potentials induced in the bulk material, invariably silicon, by adjacent trench gates interact to relieve the high electric fields which normally arise at the corners of isolated trench gates, and thus increase the breakdown capability. Therefore, it has been realised that the crowding of electric field is more likely to create problems at the edge of the device, where the outer active trench corners are unprotected.

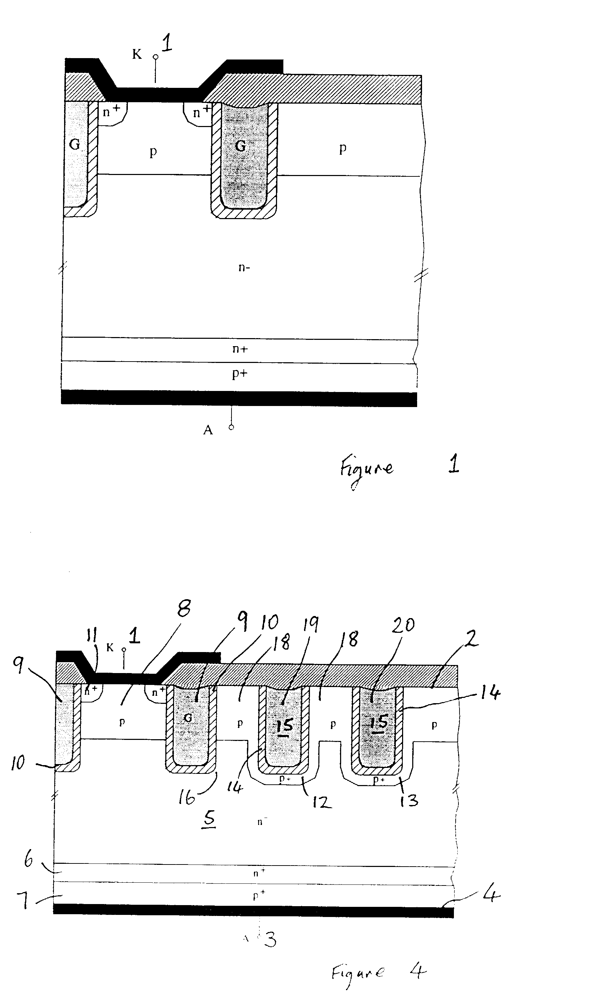

A typical IGBT trench device is shown in Figure 1. The trench on the right defines the edge of the active device; it is assumed that a repetitive trench structure continues to the left side. The breakdown occurs at the right corner of the last trench as can be seen on both the potential and electric field simulations (Figures 2 and 3). This is due to the fact that in the bulk the trench bodies act as field plates to each other and the only one left out is the trench placed at the edge of the device. In a typical example, a breakdown voltage of only 550 V is achieved which represents only 58% of the bulk breakdown.

The present invention seeks to provide a trench device in which the breakdown at the edge of the device is improved, thereby improving the performance of the device.

According to this invention, a semiconductor trench device includes an active region having one or more trenches extending from a first surface thereof with at least one p-n junction associated therewith across which current flow is controllable by a gate electrode region disposed at a side wall of the trench, and an electrically conductive region which encircles said active region, said electrically conductive region extending substantially to the depth of the bottom of said trench and being composed of a semiconductor material having a conductivity type opposite to that of the semiconductor region immediately underlying said trench.

Preferably the electrically conductive region is an electrically floating region.

By electrically floating region is meant a region which is not held at a predetermined potential or is not electrically connected via a low impedance path to any of the electrodes of the trench device to which predetermined potentials are applied.

The trench device may include several individual trenches, and typically can include a very large number of localised trenches. In such a case the electrically floating region encircles all of the trenches forming part of a common trench device around its perimeter, and in general the perimeter wall will not be circular, but will take whatever path is required, eg rectangular, hexagonal, to encompass all of the trenches.

The electrically floating region may be buried, in which case it can be regarded as a buried ring encircling the trenches, or it may extend from the surface of the device to a depth which is substantially the same as that of the trench. In this latter case, the electrically floating region may be formed by locally forming a region of the required conductivity type at the bottom of a further trench (of a depth similar to that of the trench or trenches constituting the active region) after which the further trench may be filled with an electrically insulating material or materials. This latter case is preferred, in that the electrically conductive region can be formed by the introduction of an appropriate conductivity modifier, e.g. by diffusion or ion implantation directly into the bottom surface of the trench, thereby allowing the electrical conductivity and physical dimensions of the region to be very closely controlled.

In a preferred semiconductor trench device, the active region comprises a bulk n-type region of silicon having a surface region of p-type silicon, with said trenches extending from the first surface through said p-type material into said n-type material. In such a case the electrically floating region is preferably a p+ region, that is to say a region which is much more conductive than the p-type region which extends to the surface, and preferably again, the p+ region is contiguous with the p-type region.

The effect of the electrically floating region is to modify the potential lines in the region of the bottom of said trenches, and so to reduce the potential gradient. In order to further enhance the immunity to electrical breakdown, a second electrically floating region may be provided which encircles the first electrical floating region, and in principle additional such regions could be provided to further modify the potential contours at the edge of the device.

The surface areas of the device may be large so as to accommodate a large number of trenches. To allow for surface interconnection tracks or the like, the trenches may be arranged in blocks in which the spacing between adjacent blocks may be greater than the spacing between adjacent trenches within a given block. In such a case it is desirable also to provide a said electrically conductive region between the blocks so as to improve the immunity to electrical breakdown of those trenches at the edges of the blocks. The electrically conductive region may be an electrically floating region or it may be electrically connected to a main current electrode which overlies it.

The invention is further described with reference to the accompanying drawings, in which:

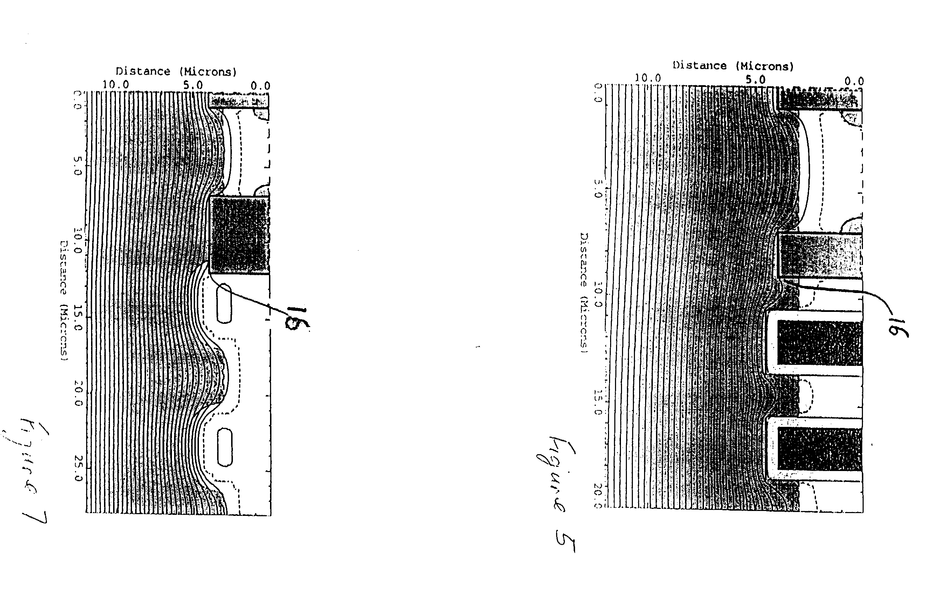

Figure 4 shows in diagrammatic form a trench device in accordance with the invention,
Figure 5 is an explanatory diagram,

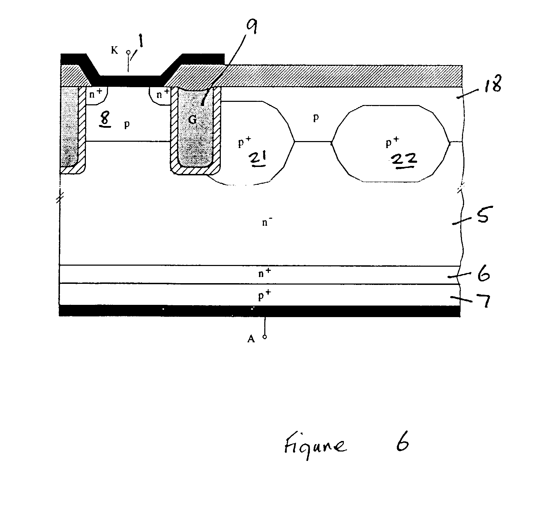

Figure 6 shows an alternative embodiment of the invention,
Figure 7 is an explanatory diagram relating thereto and

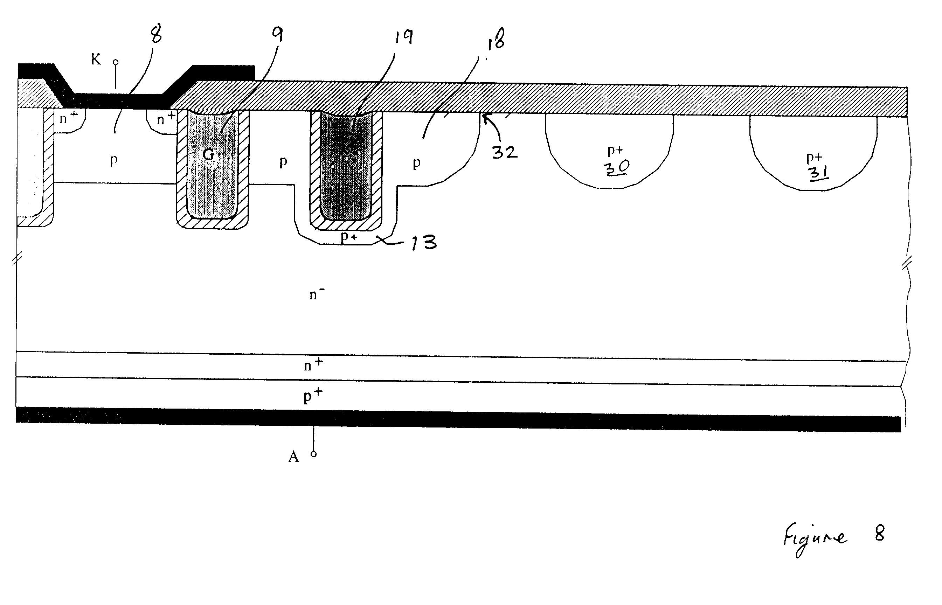

Figures 8 to 14 show further modifications thereof.

Referring to Figure 4, there is shown a sectional view of part of a semiconductor trench device, in which a silicon body is provided with a cathode electrode I at a first surface 2, and an anode electrode 3 at a second surface 4 thereof. Typically, the silicon body is formed from a flat relatively thin slice of silicon having an n-conductivity type, into which various conductivity modifying materials are introduced to form a succession of electrically different regions. In the drawing, the bulk of the device comprises the n-region 5, having relatively thin layers 6 and 7 of n+ and p+ material between it and the anode electrode 3.

A region 8 of p-type material is provided between the bulk region 5 and the first surface 2 into which a number of trenches 9 are formed. Each active trench is a region of doped polysilicon which constitutes a gate electrode which has a thin outer oxide layer 10 positioned between it and the bulk material of the device.

A small emitter region 11 is formed of n+ material at the first surface, so that a part of it is in contact with the oxide layer 10, and part in contact with the cathode electrode 1. Thus, one end of the p-n junction so formed between regions 8 and 11 is shorted out by the cathode electrode 1.

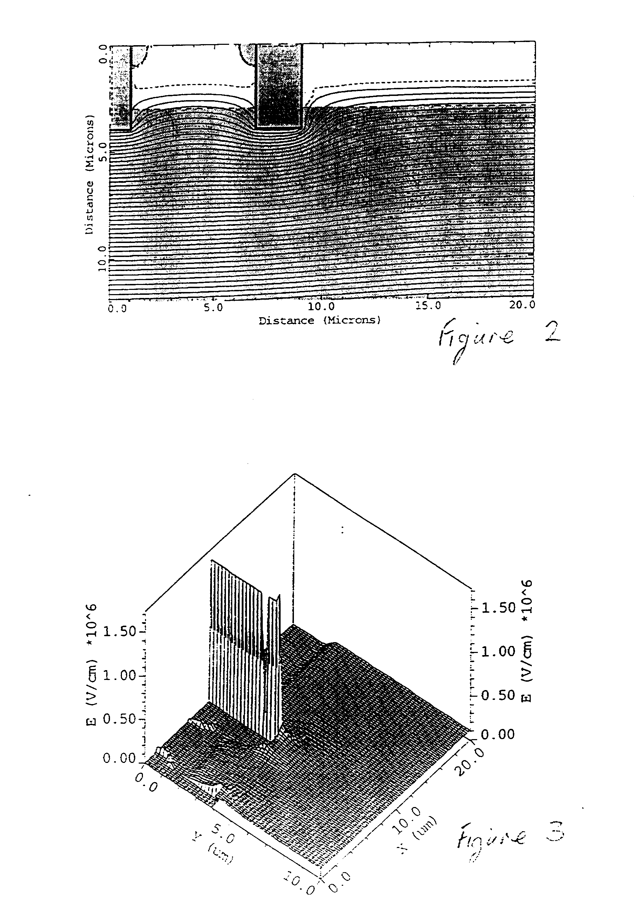

The device so far described is generally known as an IGBT (insulated gate bipolar transistor). Known devices are used to switch rapidly large currents at high voltages, and can suffer from the disadvantage that undesirable voltage breakdown can occur at voltages lower than the breakdown value of the bulk material. This appears to be due to localised voltage breakdown occurring at the lower outer corner of the outennost trench of a device, as represented by Figures 2 and 3.

This disadvantage is substantially reduced by the use of electrically floating regions 12 and 13 comprising regions of p+ material which completely encircle the active region of the device which comprises the trenches 9. Thus, the regions 12 and 13 effectively constitute the perimeter of the device, and the shape of this perimeter will be dictated by the plan layout of the active region, since it is desirable to closely control the distance between the outer trench 9 and the region 12, and the distance between the region 12 and region 13. These distances control and determine the profile of the potential gradients which exist within the bulk region 5. Typically, the distance between the outer trench 9 and the floating region 12 is about 1.5 - 4µm. The p+ regions are formed by implanting a sufficiently high concentration of material, such as boron, so that the regions 12 and 13 have a high conductivity compared to the p- region 8, which by comparison exhibits a high resistance.

A region 18, which is electrically isolated from region 8 but is of similar p-type material, is provided with the regions 12 and 13 at the bottom of trenches 19,20 for the purpose of field termination. These trenches 19,20 are conveniently formed and filled with conductive polysilicon as for the active trenches 9, or they may be filled only with an insulating material.

In Figure 4, the floating regions 12 and 13, are produced by first forming two open trenches into the bottoms of which p+ material (typically boron) is implanted and diffused or alternatively is introduced directly by diffusion, after which a thin insulation oxide layer 14 is formed on the walls of the trenches, and then the trench is filled with an oxide of silicon or with polysilicon 15. This process is a convenient one since a similar process is used to form the active trenches 9. The depth of these trenches is the same as for the active trenches 9. Furthermore, by implanting the boron directly into the bottom of the trenches to form the electrically floating regions 12,13, the electrical conductivity and physical dimensions of these regions can be fairly precisely controlled. In particular regions of very high conductivity occupying only a small area of a device can be produced at the required depth. Typically the depth of a trench is about 5 microns to 15 microns, whereas the depth of the region 8 is about 3 to 4 microns.

The effect of the floating regions 12 and 13 is illustrated in Figure 5, in which it can be seen that the shape of the potential contours is substantially modified at the critical region 16. It is found that it is no longer this critical region which determines the overall breakdown, as electrical breakdown is found to occur at or about a value of 950 volts, which corresponds to ~95% of the ideal breakdown figure of the bulk material of the device with the parameters used.

An alternative embodiment of the invention is shown in Figure 6, in which the floating trenches have been replaced by buried floating rings 21, 22 of p+ silicon, one of which, ring 21, is formed in contact with trench 9. In fact, to minimise the effect of the sharp electric field at the last (outer) trench 9, the buried ring extends a little way under the bottom of the trench. These buried floating rings are formed during the fabrication of the device which initially consists of a bulk material 5 and layers 6 and 7. P+ material is implanted into the surface of the material 5 at the required locations after which the upper layer 8 is formed by epitaxial growth. During subsequent processing of the device the regions 21 and 22 naturally extend by diffusion into region 18 of this epitaxial layer 8 thereby providing a less defined region and having a somewhat less controllable conductivity. In the event of the trench depth being greater than the typical value it is possible to utilise this embodiment without regions 21 and 22 extending fully beyond the trench depth.

The presence of the p+ diffusion under the last trench corner pushes the potential lines in the n- bulk, thus preventing the presence of high electric fields at the trench edge. The purpose of the second or subsequent p+ buried layers is to release gradually the depletion region in the bulk The electric field is now evenly shaped along the p+/n base junction and in a simulation the breakdown is predicted to occur at the right buried layer ring 22 at an estimated value of 920 volts, which corresponds to ~92% of the ideal breakdown figure of the bulk materials with the parameters used.

The resulting pattern of potential contours is shown in Figure 7, from which it can be seen that the rings 21, 22 have a substantial effect on the profile of the potential contours at the critical region 16.

Referring to Figure 8, there is shown therein a modified form of Figure 4 in which only a single floating trench is shown to protect the last, outer active trench 9. In addition, floating conductive rings 30,31 of p+ material are provided to protect the p base region which otherwise could be susceptible to voltage breakdown, particularly in the region 32.

These rings are essentially surface regions which extend into the body of the silicon only to a depth equal to that of the p region 8, e.g. 3 to 4 microns. Alternatively, these rings 30, 31 may be extended to a depth equal to or greater than region 13.

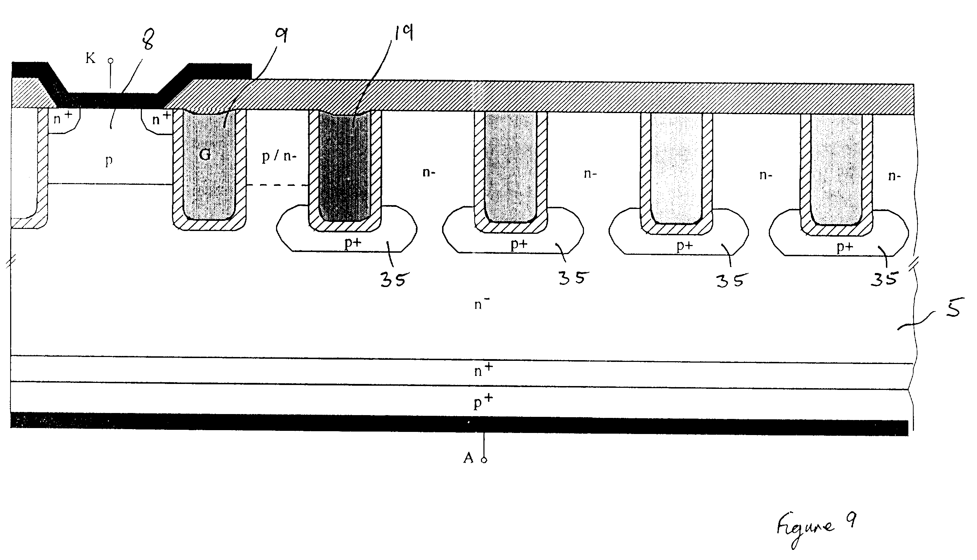

Figure 9 shows a modified version of Figure 4 in that the electrically floating p+ regions now consist of rings 35 under the trenches. These p+ rings 35 are formed by implant through the open trenches. It will be noted that the p base region 8 does not extend to these outer trenches which are formed entirely in the n type bulk material 5.

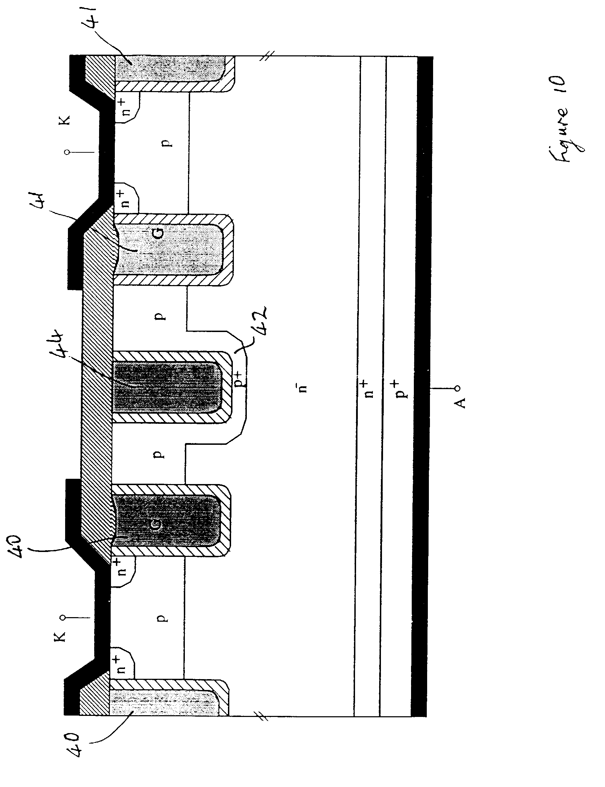

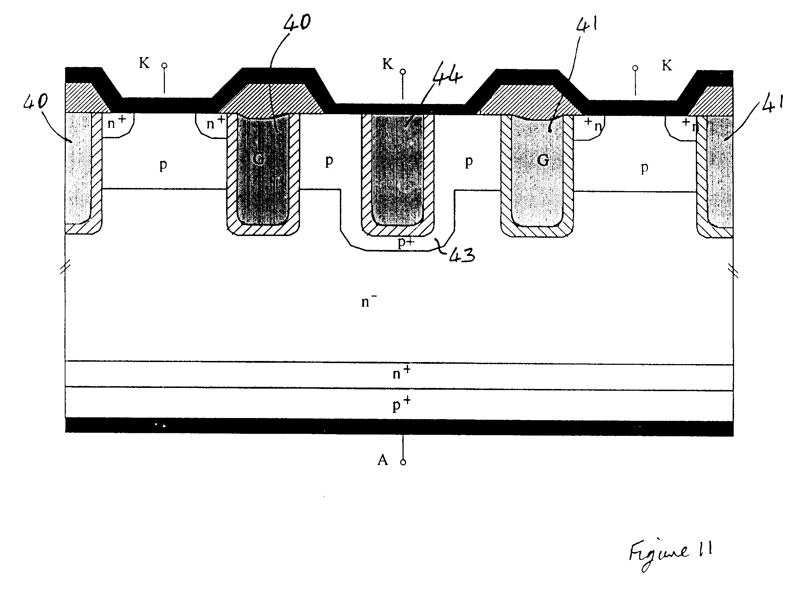

In Figures 10 and 11 the conductive regions of p+ material are used within the interior of a device and are located between blocks of trenches 40,41 which are separated by a longer distance than two adjacent trenches inside a particular block. The region 42 could be electrically floating (Figure 10) or the region 43 could be electrically connected to the cathode (Figure 11) ) and in each is located at the base of a trench 44.

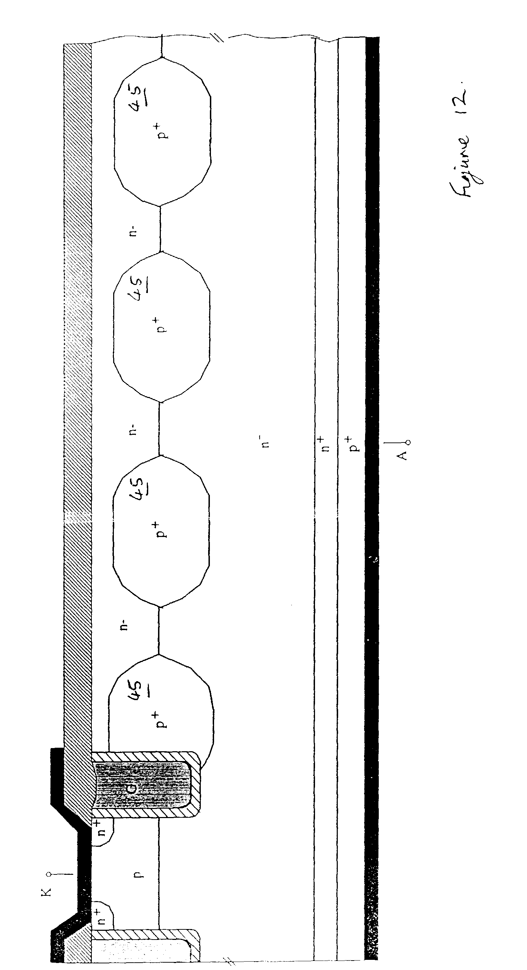

In Figure 12 several p+ buried floating rings 45 are shown. These are deep rings and so protect the outer corner of the last active trench and are formed wholly in n-type material.

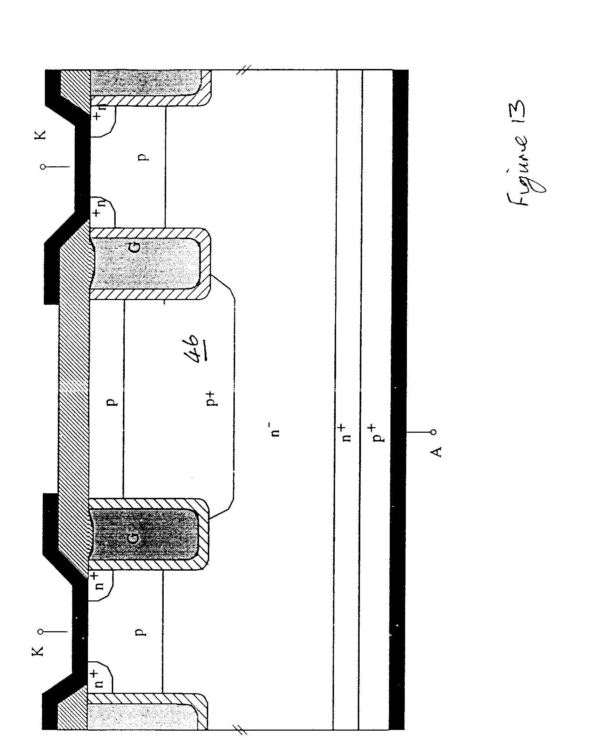

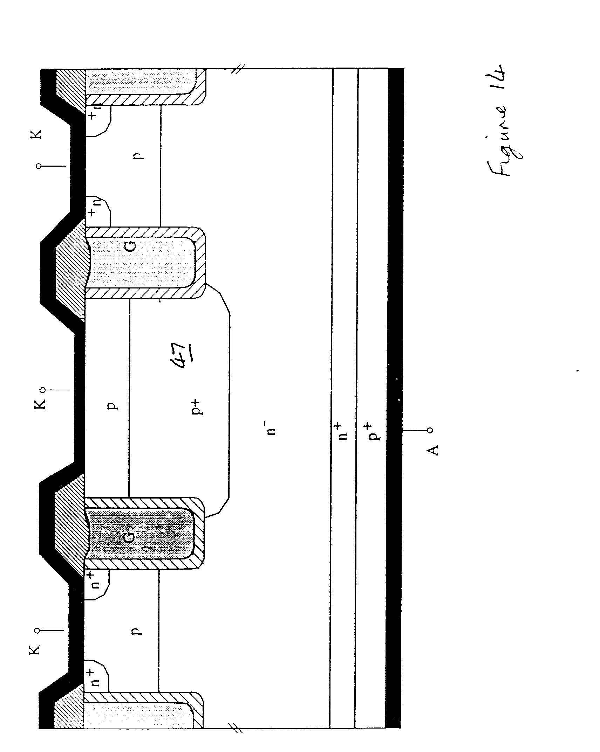

Figures 13 and 14 show the use of buried rings 46 and 47 within the interior of a device. As with Figure 10 and 11 they are positioned between adjacent blocks of active trenches. The p+ buried ring 46 can be floating (Figure 13) or the ring 47 can be electrically connected to the cathode (Figure 14).

## Claims

1. A semiconductor trench device including an active region (8,9) having one or more trenches (9) extending from a first surface (2) thereof with at least one p-n junction associated therewith across which current flow is controllable by a gate electrode region (9) disposed at a side wall of the trench, and an electrically conductive region (12) which encircles said active region, said electrically conductive region extending substantially to the depth of the bottom of said trench and being composed of a semiconductor material having a conductivity type opposite to that of the semiconductor region immediately underlying said trench.

2. A device as claimed in Claim 1 and wherein said electrically conductive region is an electrically floating region.

3. A device as claimed in Claim 2 and wherein said electrically floating region encircles all of the trenches forming part of a common trench device around its perimeter.

4. A device as claimed in Claim 2 or 3 and wherein the electrically floating region extends from the surface of the device to a depth which is substantially the same as the trench.

5. A device as claimed in Claim 4 and wherein the electrically floating region is in part a local region of the required conductivity type formed at the bottom of a further trench.

6. A device as claimed in Claim 5 and wherein said further trench is composed of an electrically insulating material.

7. A device as claimed in any of Claims 2 to 6 and wherein the active region comprises a bulk n-type region of silicon having a surface region of p-type silicon, with said trenches extending from the first surface through said p-type material into said n-type material.

8. A device as claimed in Claim 7 and wherein the electrically floating region is a p+ region.

9. A device as claimed in Claim 8 and wherein said p+ region is contiguous with the p region.

10. A device as claimed in Claim 2 or 3 and wherein the electrically floating region is a buried ring of the required conductivity type.

11. A device as claimed in any of the preceding claims and wherein a second electrically conductive region is provided which encircles the first electrically conductive region.

12. A device as claimed in any of the preceding claims and wherein additional said electrically conductive regions are located between adjacent blocks of trenches.
